# EUROPÄISCHE PATENTANMELDUNG

(11) **EP 3 386 109 A1**
(43) Veröffentlichungstag der Anmeldung: **10.10.2018**
(21) Anmeldenummer: 17164923.9
(22) Anmeldetag: 05.04.2017
(51) Int. Cl.: H03K 17/97

(54) **SCHALTVORRICHTUNG**

(71) Anmelder: RAFI GmbH & Co. KG, 88276 Berg (DE)
(72) Erfinder: Natterer, Nikola, 88276 Berg (DE); Koch, Werner, 88276 Berg (DE); Dürr, Stefan, 88273 Fronreute (DE)
(74) Vertreter: Engelhardt, Volker

(57) **Zusammenfassung**

Bei einer Schaltvorrichtung (1) zur Erzeugung eines elektrischen Signals, umfassend:
- wenigstens einen elektrisch leitfähigen Betätigungskörper (7), der entlang einer Längsachse (3) beweglich gelagert ist,
- wenigstens ein Federelement (10), durch das der Betätigungskörper (7) entlang der Längsachse (3) abgestützt ist, und
- wenigstens einen induktiven Sensor (6), der das elektrische Signal bei einer Annäherung des Betätigungskörpers (7) erzeugt,
soll die Schaltvorrichtung (1) für Außenanwendungen, insbesondere an Fahrzeugen, einsetzbar sein und eine taktile Rückmeldung erzeugen und mittels einer Lichtquelle beleuchtet sein. Dies ist dadurch erreicht,
- dass das Federelement (10) aus einem elastischen und elektrisch isolierenden Werkstoff einstückig hergestellt ist und mindestens einen Biegeknickbereich (11) und eine Kuppe (13) aufweist, und
- dass der Betätigungskörper (7) auf der dem induktiven Sensor (6) zugewandten Seite der Kuppe (13) angeordnet ist.

## Beschreibung

Die Erfindung bezieht sich auf eine Schaltvorrichtung nach dem Oberbegriff des Patentanspruchs 1.

Aus der DE 10 2012 112 248 A1 ist eine Schaltvorrichtung vorbekannt, die eine Zustellbewegung in ein entsprechendes elektrisches Schaltsignal umwandelt. Die Schaltvorrichtung besteht aus einer ringförmigen Fassung, in der ein elektrisch nicht leitfähiges Tastenteil mit einem Metallkern angeordnet ist, dass mittels einer Federeinrichtung in einer Ausgangsposition gehalten ist. Bei einer Betätigung durch ein Bedienpersonal wird das Tastenteil mit dem Metallkern in Richtung einer Abdeckplatte einer Anzeigevorrichtung bewegt, hinter der sich eine Sensorelektrode befindet, die die Annäherung des Metallkerns des Tastenteils registriert und ein elektrisches Schaltsignal generiert.

Bei einer derartigen Schaltvorrichtung handelt es sich um eine Bedien-Vorrichtung bzw. eine Mensch-Maschine-Schnittstelle, die typischerweise auf einer Abdeckplatte eines berührungssensitiven Bildschirms, auch Touchscreen genannt, angeordnet ist.

Nachteilig an diesem Stand der Technik ist, dass derartige Schaltvorrichtungen nicht für Außenanwendungen bzw. Outdoor-Anwendungen geeignet sind, da beispielsweise Feuchtigkeit zu einem ungewünschten Schaltverhalten führt. Darüber hinaus ist an diesem Stand der Technik nachteilhaft, dass derartige Schaltvorrichtungen keine eigenständige Beleuchtung aufweisen, sondern vielmehr auf eine Beleuchtung seitens der Abdeckplatte angewiesen sind. Aufgrund des Schattenwurfes der Fassung ist lediglich die Kontur des Tastenfeldes schemenhaft für ein Bedienpersonal wahrnehmbar.

Es ist daher Aufgabe der Erfindung, eine Schaltvorrichtung der eingangs genannten Gattung derart weiterzubilden, dass diese für Außenanwendungen, insbesondere an Fahrzeugen, einsetzbar ist, eine taktile Rückmeldung erzeugt und zusätzlich mittels einer Lichtquelle beleuchtet werden kann. Die Schaltvorrichtung soll kostengünstig herstellbar sein und auf besonders einfache Weise montierbar sein und eine hohe Systemsicherheit bieten.

Die Aufgabe ist erfindungsgemäß durch die Merkmale des kennzeichnenden Teils von Patentanspruch 1 gelöst.

Weitere vorteilhafte Weiterbildungen der Erfindung ergeben sich aus den Unteransprüchen.

Dadurch, dass das Federelement aus einem elastischen und elektrisch isolierenden Werkstoff einstückig hergestellt ist und mindestens einen Biegeknickbereich und eine Kuppe aufweist, und dass das Betätigungselement an der Kuppe fixiert ist, erzeugt die Schaltvorrichtung bei der Betätigung eine taktile Rückmeldung und ist unempfindlich gegen Luftfeuchte und dicht bezüglich Wasser, wodurch die Schaltvorrichtung besonders für den Einsatz in Außenbereichen geeignet ist. Darüber hinaus ist das Federelement einer derartigen Schaltvorrichtung mittels eines einfachen Spritzgussverfahrens herstellbar, die Montage besonders einfach und das Schaltverhalten robust gegenüber äußeren klimatischen Einflüssen.

Darüber hinaus hat es sich als besonders vorteilhaft erwiesen, wenn der Betätigungskörper ringförmig ausgebildet ist. Der Betätigungskörper ist auf der einem induktiven Sensor zugewandten Seite koaxial auf der Längsachse auf der Kuppe angeordnet. Durch den Betätigungskörper ist die Kuppe des Federelementes versteift und bedingt durch die Ringform des Betätigungskörpers ist der Betätigungskörper entlang der Längsachse lichtdurchlässig, wodurch eine Beleuchtung der Schaltvorrichtung möglich ist.

Gemäß einer weiteren vorteilhaften Ausgestaltung ist auf der dem induktiven Sensor zugewandten Seite der Kuppe ein Anschlag angeformt oder angearbeitet, durch den die Zustellbewegung des Federelementes bei einem Schaltvorgang begrenzt ist. Der Anschlag kann zylinder- oder ringförmig von der Kuppe abstehen. Es hat sich als besonders vorteilhaft erwiesen, wenn der Zustellweg durch den Anschlag auf maximal 5 mm, besonders bevorzugt auf 2-3 mm, beschränkt ist.

Darüber hinaus ist es weiterhin besonders vorteilhaft, wenn die Kuppe eine Aussparung aufweist, die sich entlang der Längsachse auf der dem Sensor zugewandten Seite durch diese bereichsweise oder vollständig erstreckt. Durch die Aussparung ist insbesondere in Kombination mit dem ringförmigen Betätigungskörper ein lichtdurchlässiger Bereich bzw. ein optischer Durchgang in der Kuppe geschaffen. Somit sind Lichtstrahlen von einer Lichtquelle im Inneren der Schaltvorrichtung von außen für Bedienpersonal optisch wahrnehmbar. Die Aussparung ist besonders bevorzugt als Sacklochbohrung ausgebildet, wodurch die Kuppe einen lichtdurchlässigen Bereich bildet.

Gemäß einer weiteren bevorzugten Ausgestaltung ist es besonders vorteilhaft, wenn das Federelement mit dem Betätigungskörper in einer Durchgangsöffnung eines Gehäuses angeordnet ist. Das Gehäuse kann zusammen mit einer Bedienkappe das Federelement umschließen, wobei auf der dem Federelement gegenüberliegenden Seite am Gehäuse der induktive Sensor angeordnet ist. Die Bedienkappe kann aus einem nicht durchlässigen Material hergestellt sein und ist seitlich gelagert in dem Gehäuse auf dem Federelement abgestützt.

Eine weitere vorteilhafte Ausgestaltung sieht vor, dass das Federelement durch das Gehäuse an einer Leiterplatte fixiert ist. Das Gehäuse weist hierzu geeignete Anlageflächen auf, durch die ein Sockel des Federelementes auf der Leiterplatte fixiert ist. Der induktive Sensor befindet sich dabei im Bereich der Leiterplatte, also in Zustellrichtung auf, in oder unterhalb der Leiterplatte. An dem Gehäuse können eine oder mehrere Clipsverbindungen angeformt sein, durch die das Gehäuse an der Leiterplatte unkompliziert fixiert werden kann. Die Leiterplatte kann auch integraler Bestandteil des Gehäuses sein, wobei das Gehäuse ein- oder mehrteilig die Leiterplatte umgibt. Die elektrischen Kontakte des induktiven Sensors sind dabei durch das Gehäuse geführt.

Eine weitere vorteilhafte Weiterbildungen der Schaltvorrichtung sieht vor, dass eine Lichtquelle in dem Gehäuse vorgesehen ist, deren emittierte Lichtstrahlen durch das Federelement, durch den lichtdurchlässigen Bereich der Kuppe oder durch die Aussparung der Kuppe von außen durch das Bedienpersonal wahrnehmbar sind. Die Aussparung und die Lichtquelle sind dabei derart dimensioniert, dass die Lichtquelle im betätigten Zustand der Schaltvorrichtung durch die Aussparung umgeben ist. Die Aussparung kann weiterhin nach Art einer Durchgangsbohrung die Kuppe vollständig durchdringen. Darüber hinaus kann gemäß einer weiteren vorteilhaften Ausgestaltung in die Aussparung ein Lichtleiter eingesetzt sein. Der Lichtleiter kann in der Aussparung mittels einer Klemm-, Klebe- oder formschlüssigen Verbindung fixiert sein.

Gemäß einer weiteren Ausgestaltung ist es besonders vorteilhaft, wenn das Federelement aus dem Sockel, dem Biegeknickbereich und der Kuppe einstückig als ein Spritzgussteil hergestellt ist. Als Werkstoffe eignen sich insbesondere elastische Werkstoffe, beispielsweise Silikon oder dergleichen, die eine geringe Opazität aufweisen. Hierbei kann die Opazität zum Beispiel bei schwarzen Silikon durch eine Ausdünnung des Materials im Bereich der Kuppe entstehen. Der Sockel und die Kuppe sind dabei derart eingerichtet, dass diese in Relation zu dem Biegeknickbereich eine vielfach höhere Steifigkeit aufweisen. Somit ist sichergestellt, dass bei der Betätigung der Schaltvorrichtung lediglich das Federelement im Bereich des Biegeknickbereichs ausgelenkt wird. Die Wandstärken t bzw. das Verhältnis der Wandstärke des Biegeknickbereiches zu dem Sockel bzw. zu der Kuppe beträgt mindestens 1:2. Der Sockel dient dabei im Wesentlichen als Abstützung des Biegeknickbereiches und der Befestigung des Federelementes auf der Leiterplatte.

Besonders vorteilhaft ist es, wenn der Biegeknickbereich in einem Winkel w von 45° > w > 0° zu der Längsachse verläuft, um eine besonders ausgeprägte taktile Rückmeldung zu erzeugen. Insbesondere kleine Winkel, die annähernd 0° betragen weisen eine sehr ausgeprägte taktile Rückmeldung auf.

Darüber hinaus ist besonders vorteilhaft, wenn die Schaltvorrichtung als Hubtaster oder als Wippenschalter ausgebildet ist. Der Hubtaster umfasst typischerweise ein Federelement und einen induktiven Sensor, währenddessen der Wippenschalter aus zwei parallel und beabstandeten Federelementen und mindestens zwei induktiven Sensoren gebildet ist.

In der Zeichnung sind fünf Ausführungsbeispiele einer erfindungsgemäßen Schaltvorrichtung dargestellt, die nachfolgend näher erläutert sind. Im Einzelnen zeigt:
- Figur 1a: ein erstes Ausführungsbeispiel einer Schaltvorrichtung im unbetätigten Zustand, mit einem Gehäuse, in dessen Aufnahmeöffnung ein Federelement mit einem Betätigungskörper eingesetzt ist,
- Figur 1b: die Schaltvorrichtung gemäß Figur 1 a im betätigten Zustand,
- Figur 2a: ein zweites Ausführungsbeispiel der Schaltvorrichtung mit einem ringförmigen Betätigungskörper, der koaxial zusammen mit einer Aussparung einen lichtdurchlässigen Bereich in der Kuppe des Federelementes bildet,
- Figur 2b: die Schaltvorrichtung gemäß Figur 2a im betätigten Zustand,
- Figur 3a: ein drittes Ausführungsbeispiel der Schaltvorrichtung, die als Wippenschalter ausgebildet ist,
- Figur 3b: die Schaltvorrichtung gemäß Figur 3a im betätigten Zustand,.
- Figur 4a: ein viertes Ausführungsbeispiel der Schaltvorrichtung mit einem Betätigungskörper, der als Schnappscheibe ausgebildet ist,
- Figur 4b: die Schaltvorrichtung gemäß Figur 4a im betätigten Zustand,
- Figur 5a: ein fünftes Ausführungsbeispiel der Schaltvorrichtung, mit einem ringförmigen Betätigungskörper, und
- Figur 5b: die Schaltvorrichtung gemäß Figur 5a im betätigten Zustand.

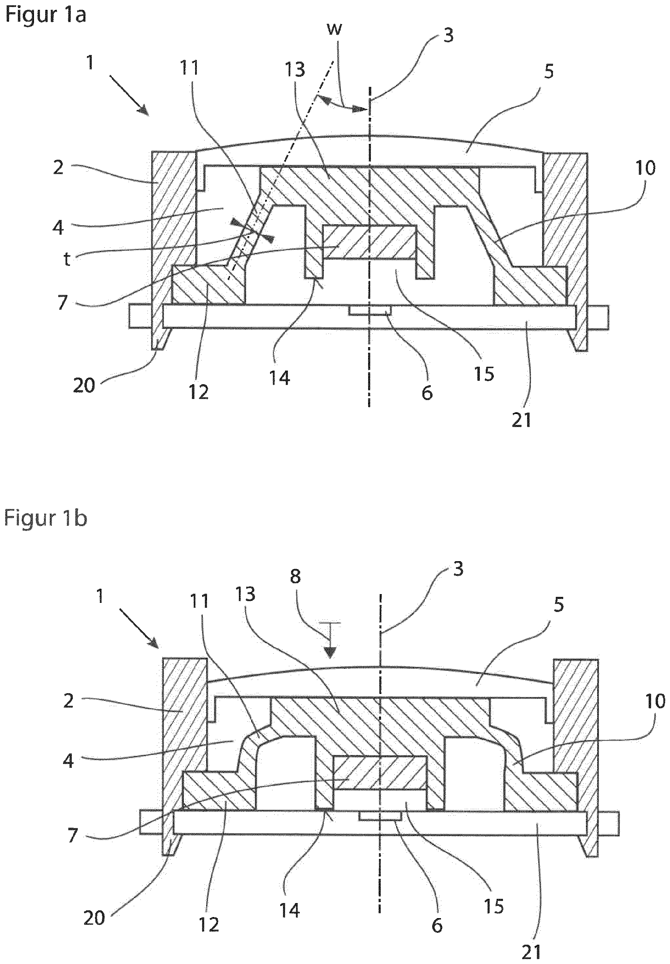

In Figur 1a ist eine Schaltvorrichtung 1 zur Umwandlung einer mechanischen Zustellbewegung entlang einer Zustellrichtung 8 in ein elektrisches Signal zu entnehmen, durch das ein elektrisches Gerät gesteuert ist. Die Schaltvorrichtung 1 besteht aus einem Gehäuse 2, in das eine Aufnahmeöffnung 4 eingearbeitet ist. In der Aufnahmeöffnung 4 des Gehäuses 2 sind eine Bedienkappe 5 und ein Federelement 10 eingesetzt, die entlang einer Längsachse 3 beweglich gelagert sind. Das rotationssymmetrische Federelement 10 ist aus einem elastischen Werkstoff hergestellt und umfasst einen Sockel 12, einen Biegeknickbereich 11 und eine Kuppe 13, wobei der Biegeknickbereich 11 zwischen dem Sockel 12 und der Kuppe 13 angeordnet ist. An der zylinderförmigen Kuppe 13 ist ein scheibenförmiger Betätigungskörper 7 befestigt, der aus einem elektrisch leitfähigen Werkstoff hergestellt ist.

Das Gehäuse 2 ist auf eine Leiterplatte 21 mittels einer Clipsverbindung 20 fixiert und arretiert das Federelement 10 auf der Leiterplatte 21. Das Gehäuse 2 kann jedoch auch an die Leiterplatte 21 angeklebt oder anderweitig fixiert sein, wobei die Leiterplatte 21 integraler Bestandteil des Gehäuses 2 sein kann.

Auf der Leiterplatte 21 ist ein induktiver Sensor 6 positioniert, der bei Annäherung des Betätigungskörpers 7 mit diesem zusammenwirkt und ein Schaltsignal generiert. Der induktive Sensor 6 erzeugt mittels einer Induktivität oder Spule ein magnetisches Feld, dass durch den Betätigungskörper 7 bei der Betätigung der Schaltvorrichtung 1 gestört ist. Die Störung des magnetischen Feldes wird durch den induktiven Sensor 6 erfasst und das Schaltsignal ist generiert.

Die taktile Rückmeldung der Schaltvorrichtung 1 ist durch das schlagartige biegeknicken des Biegeknickbereichs 11 erzeugt. Die Wandstärke t des Biegeknickbereichs 11 ist um ein Vielfaches kleiner als die Wandstärke der Kuppe 13 und des Sockels 12, wodurch die Steifigkeit des Biegeknickbereichs 11 deutlich geringer bemessen ist, als die Steifigkeit der Kuppe 13 und des Sockels 12. Bei der Betätigung der Schaltvorrichtung 1 ist durch ein Aufbringen eines Tastendruckes eine Kraft entlang der Längsachse 3 in Zustellrichtung 8 des induktiven Sensors 6 auf die Kuppe 13 mittels der Bedienkappe 5 aufgebracht, wodurch der Biegeknickbereich 11 an einem vorbestimmten Druckpunkt schlagartig knickt und die Kuppe 13 entlang der Längsachse 3 in Richtung des induktiven Sensors 6 verschoben ist. Nach der Betätigung ist aufgrund der Federeigenschaften des Federelementes 10 der Ausgangszustand wiederhergestellt.

Um die taktile Rückmeldung möglichst ausgeprägt zu gestalten, ist der Biegeknickbereich 11 kegelförmig ausgebildet und die Schenkel des Kegels sind in einem Winkel von w= 30° zu der Längsachse 3 geneigt. Je kleiner der Winkel w ist, desto ausgeprägter ist die taktile Rückmeldung und vice versa.

Die Kuppe 13 des Federelementes 10 weist auf der der Leiterplatte 21 zugewandten Seite eine Aussparung 15 und einen Anschlag 14 auf. Der Anschlag 14 ist durch die Aussparung 15 ringförmig ausgebildet und begrenzt, wie in Figur 1b dargestellt, die maximale Zustellung der Kuppe 13 bei einer Betätigung entlang der Längsachse 3 in Richtung des induktiven Sensors 6. Innerhalb der Aussparung 15 ist der Betätigungskörper 7 eingesetzt, wobei der Betätigungskörper 7 dort eingeklebt oder formschlüssig befestigt sein kann. Der Anschlag 14 ist typischerweise derart ausgebildet, dass der maximale Hub des Sockels 12 entlang der Längsachse 3 ca. 2 mm beträgt.

Die Tiefe der Aussparung 15 entspricht mindestens der Dicke des Betätigungskörpers 7 und ist dabei derart bemessen, dass der Betätigungskörper 7 mindestens im betätigten Zustand in dem Magnetfeld des induktiven Sensors 6 angeordnet ist.

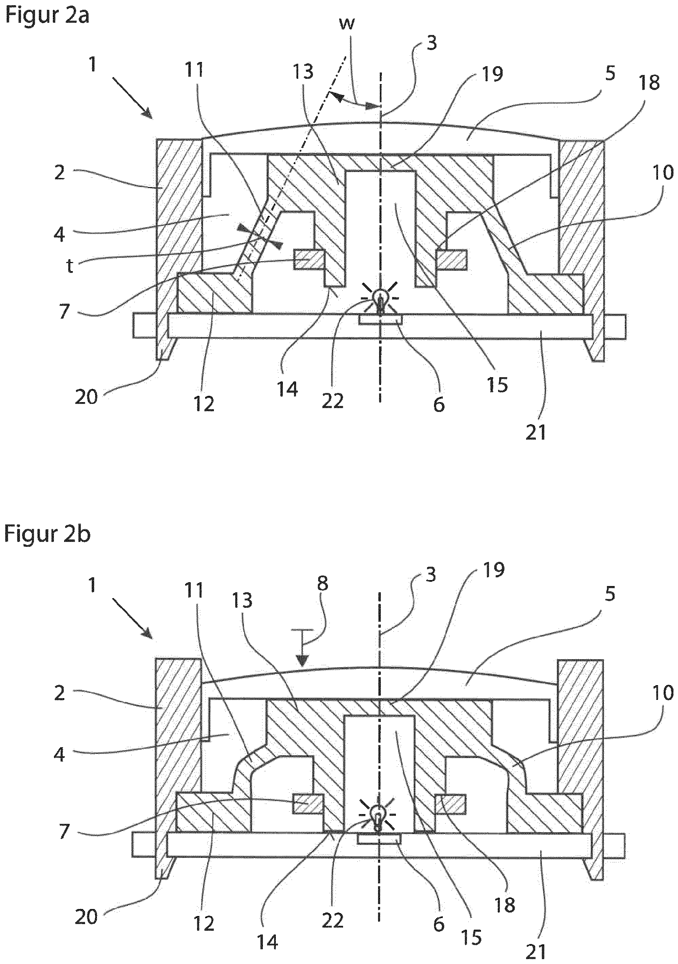

Den Figuren 2a und 2b ist ein zweites Ausführungsbeispiel der induktiven Schaltvorrichtung 1 zu entnehmen, die mittels einer Lichtquelle 22 beleuchtbar ist. Die Bedienkappe 5 ist hierzu bei entsprechender Wandstärke des Materials aus einem lichtdurchlässigen Werkstoff hergestellt.

Die Aussparung 15 in der Kuppe 13 erstreckt sich nach Art einer Sacklochbohrung entlang der Längsachse 3 von der dem induktiven Sensor 6 zugewandten Seite der Kuppe 13 bis annähernd zu der abgewandten Seite der Kuppe 13, wodurch die Kuppe 13 einen lichtdurchlässigen Bereich 19 aufweist, der unempfindlich gegen Luftfeuchte und dicht bezüglich Wasser ist..

Die Kuppe 13 ist durch die Aussparung 15 bereichsweise als Hohlzylinder ausgebildet und auf der dem Sensor 6 zugewandten Seite der Kuppe 13 ist ein Absatz 18 ausgebildet. Auf den Absatz 18 ist der ringförmige und elektrisch leitfähige Betätigungskörper 7 aufgesetzt, wobei der Betätigungskörper 7 an dem Absatz 18 mittels einer Klebeverbindung fixiert ist. Die Verbindung kann jedoch auch als Klemm- oder Steckverbindung ausgebildet sein.

Es versteht sich von selbst, dass die Aussparung 15 auch nach Art einer Durchgangsbohrung ausgebildet sein kann. In die Aussparung 15 kann darüber hinaus ein Lichtleiter eingesetzt, eingeklemmt oder eingeklebt sein.

Die Lichtquelle 22 ist auf der dem Sensor 6 zugewandten Seite des Federelementes 10 auf der Leiterplatte 21 angeordnet und die durch die Lichtquelle 22 emittierten Lichtstrahlen sind durch den ringförmigen Betätigungskörper 7, die Aussparung 15 und durch den lichtdurchlässigen Bereich 19 für das Bedienpersonal wahrnehmbar. Die Kuppe 13, die Aussparung 15, der Betätigungskörper 7 und die Lichtquelle 22 sind hierfür besonders bevorzugt entlang der Längsachse 3 ausgerichtet.

Der Anschlag 14 bzw. die Aussparung 15 sind dabei derart dimensioniert, dass im betätigten Zustand, dargestellt in Figur 2b, die Lichtquelle 22 innerhalb der Aussparung 15 angeordnet ist wodurch sichergestellt ist, dass auch im betätigten Zustand der Schaltvorrichtung 1 eine Beleuchtung der Bedienkappe 5 möglich ist.

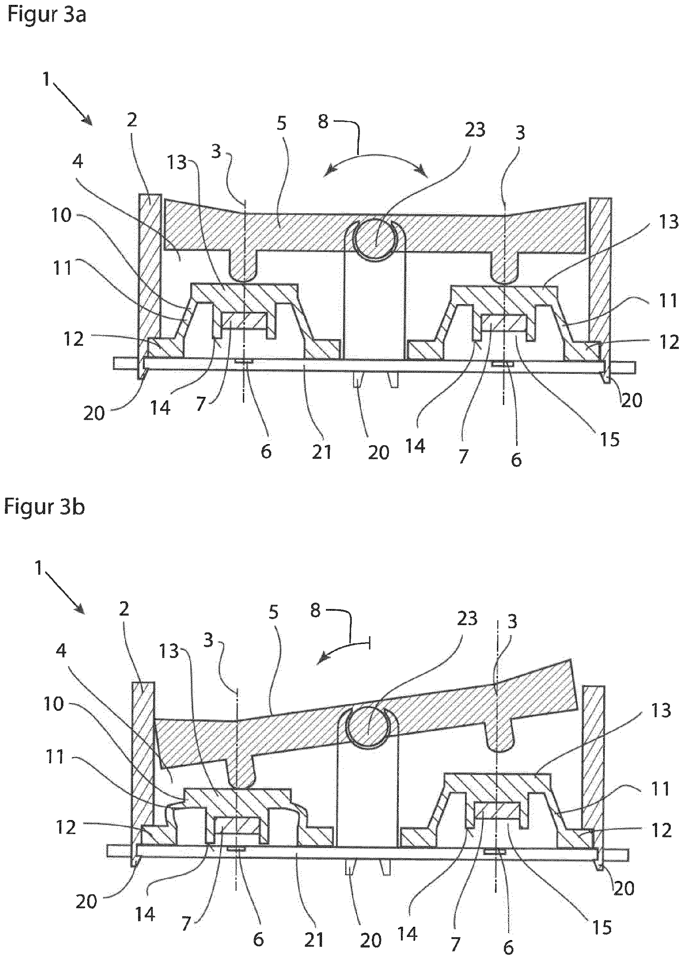

Aus den Figuren 3a und 3b ist ein drittes erfindungsgemäßes Ausführungsbeispiel der Schaltvorrichtung 1 ersichtlich. Die Schaltvorrichtung 1 ist als Wippenschalter ausgebildet und umfasst ein Gehäuse 2, eine Bedienkappe 5, zwei Federelemente 10, zwei Betätigungskörper 7 und zwei induktive Sensoren 6, wobei jeweils eines der Federelemente 10, einer der Betätigungskörper 7 und einer der induktiven Sensoren 6 eine Einheit in Analogie zu der Schaltvorrichtung gemäß den Ausführungsbeispielen, dargestellt in den Figuren 1a bis 2b, bilden.

Die Bedienkappe 5 ist mittels eines Drehgelenkes 23 nach Art einer Wippe an dem Gehäuse 2 gelagert, wobei die Lage der Bedienkappe 5 durch das mechanische Gleichgewicht zwischen den beiden Federelementen 10 vorgegeben ist.

Bei der Betätigung der Schaltvorrichtung 1 durch ein Bedienpersonal ist die Bedienkappe 5 relativ zu dem Gehäuse um das Drehgelenk 23 verschwenkt. Infolgedessen ist eine Kraft auf die entsprechende Kuppe 13 mittels der Bedienkappe 5 aufgebracht, wodurch der Biegeknickbereich 11 des entsprechenden Federelementes 10 an dem vorbestimmten Druckpunkt schlagartig biegeknickt und die Kuppe 13 entlang der Längsachse 3 in Zustellrichtung 8 des entsprechenden induktiven Sensors 6 verschoben ist. Der induktive Sensor 6 erfasst diese Änderung in seinem magnetischen Feld und ein Schaltsignal ist durch diesen ausgegeben.

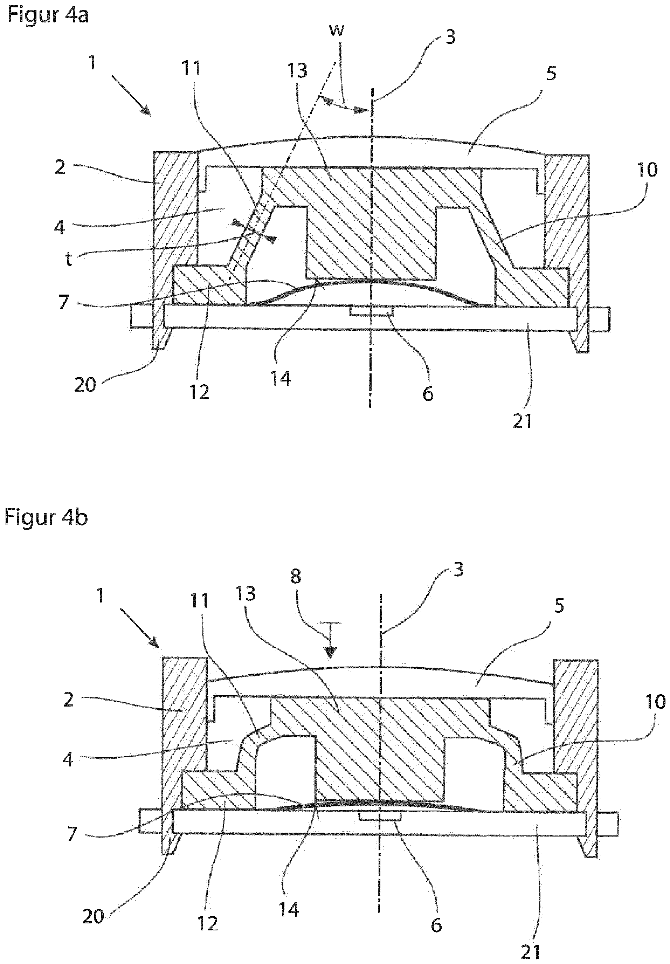

Ein viertes erfindungsgemäßes Ausführungsbeispiel ist aus den Figuren 4a und 4b ersichtlich. Zwischen der Kuppe 13 und dem induktiven Sensor 6 ist eine Schnappscheibe 16 als Betätigungskörper 7 angeordnet. Die Schnappscheibe 16 ist aus einem elektrisch leitfähigen und magnetischen Werkstoff hergestellt und ist einerseits auf der Leiterplatte 21 abgestützt und steht andererseits in mechanischen Wirkkontakt mit der Kuppe 13. Durch die Schnappscheibe 16 kann der Widerstand - also der benötigte Tastendruck - beim Betätigen der Schaltvorrichtung 1 durch ein Bedienpersonal eingestellt werden. Darüber hinaus erhöht die Schnappscheibe 16 die rückstellende Federkraft der Bedienkappe 5 sowie die taktile Rückmeldung für das Bedienpersonal.

Bei einer Betätigung der Schaltvorrichtung 1 ist die Kuppe 13 auf die Schnappscheibe 16 gedrückt. Bei einem vorgegebenen Tastendruck ist die Schnappscheibe 16 schlagartig aus einem stabilen Zustand in einen metastabilen bzw. den betätigten Zustand durch eine elastische Verformung überführt, wodurch die taktile und eine akustische Rückmeldung generiert ist. Durch die Verformung der Schnappscheibe 16 ist diese in Richtung des induktiven Sensors 6 verformt und das magnetische Feld des induktiven Sensors 6 erfährt eine erfassbare Veränderung. Folge dessen ist das Schaltsignal generiert.

Das Federelement 10 und die Schnappscheibe 16 sind dabei derart aufeinander abgestimmt, dass sowohl das Federelement 10 als auch die Schnappscheibe 16 bei einem vorgegebenen Tastendruck gleichzeitig eine taktile Rückmeldung erzeugen. Es versteht sich von selbst, dass das Federelement 10 und die Schnappscheibe 16 auch bei unterschiedlichen Tastendrücken mehrere taktile Rückmeldungen erzeugen, wodurch beispielsweise eine besondere taktile Erfahrung für das Bedienpersonal generiert ist.

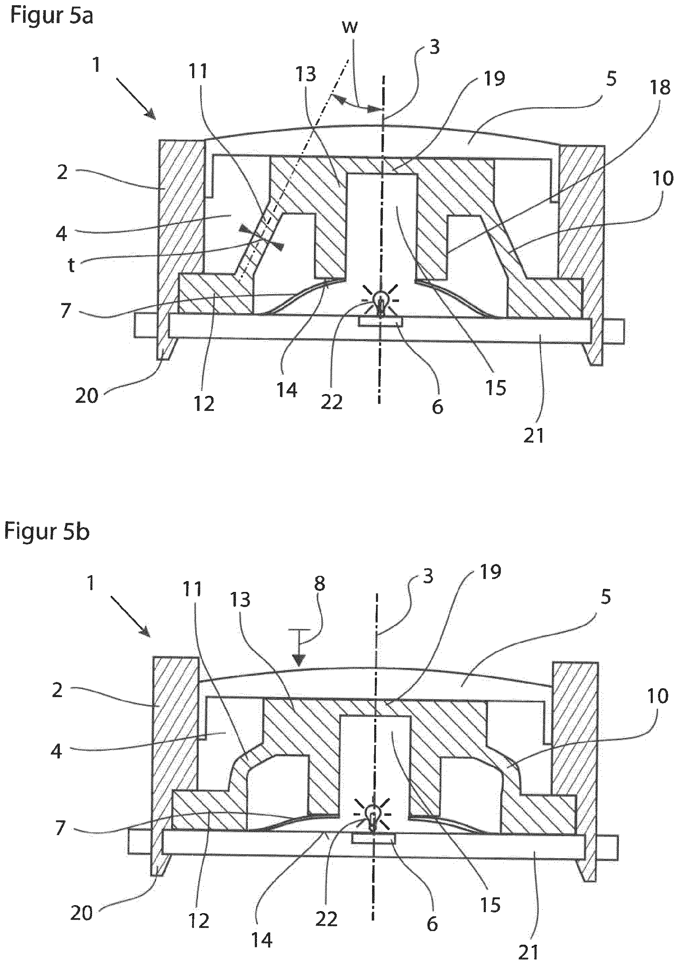

Die Schnappscheibe 16 kann entsprechend des in den Figuren 5a und 5b dargestellten fünften Ausführungsbeispiels auch ringförmig ausgebildet sein. Die ringförmige Schnappscheibe 16 ist zusammen mit der Lichtquelle 22 koaxial auf der Längsachse 3 ausgerichtet. Die Ringform der Schnappscheibe 16 ist dabei an die Form der Kuppe 13 bzw. der Aussparung 15 angepasst, wodurch die von der Lichtquelle 22 emittierten Lichtstrahlen durch die Aussparung 15 zu dem lichtdurchlässigen Bereich 19 geleitet sind. Für ein Bedienpersonal sind somit die Lichtstrahlen durch die Lichtdurchlässigkeit Bedienkappe 5 wahrnehmbar.

## Patentansprüche

1. Schaltvorrichtung (1) zur Erzeugung eines elektrischen Signals, umfassend:
- wenigstens einen elektrisch leitfähigen Betätigungskörper (7), der entlang einer Längsachse (3) beweglich gelagert ist,
- wenigstens ein Federelement (10), durch das der Betätigungskörper (7) entlang der Längsachse (3) abgestützt ist, und
- wenigstens einen induktiven Sensor (6), der das elektrische Signal bei einer Annäherung des Betätigungskörpers (7) erzeugt,
**dadurch gekennzeichnet,**
- **dass** das Federelement (10) aus einem elastischen und elektrisch isolierenden Werkstoff einstückig hergestellt ist und mindestens einen Biegeknickbereich (11) und eine Kuppe (13) aufweist, und
- **dass** der Betätigungskörper (7) auf der dem induktiven Sensor (6) zugewandten Seite der Kuppe (13) angeordnet ist.

2. Schaltvorrichtung (1) nach Patentanspruch 1,
**dadurch gekennzeichnet,**
**dass** der Betätigungskörper (7) ringförmig ausgebildet ist.

3. Schaltvorrichtung (1) nach Patentanspruch 1 oder 2,
**dadurch gekennzeichnet,**
**dass** die Kuppe (13) einen Anschlag (14) aufweist, durch den der Bewegungsbereich der Kuppe (13) begrenzt ist.

4. Schaltvorrichtung (1) nach einem der vorgenannten Patentansprüche,
**dadurch gekennzeichnet,**
**dass** die Kuppe (13) in der Längsachse (3) eine Aussparung (15) aufweist.

5. Schaltvorrichtung (1) nach Patentanspruch 4,
**dadurch gekennzeichnet,**
**dass** in der Aussparung (15) des Betätigungskörpers (7) eine Lichtquelle (22) eingesetzt ist.

6. Schaltvorrichtung (1) nach Patentanspruch 4 oder 5,
**dadurch gekennzeichnet,**
**dass** die Aussparung (15) einen lichtdurchlässigen Bereich (19) aufweist.

7. Schaltvorrichtung (1) nach einem der vorgenannten Patentansprüche,
**dadurch gekennzeichnet,**
**dass** das Federelement (10) aus einem lichtdurchlässigen Silikonwerkstoff hergestellt ist.

8. Schaltvorrichtung (1) nach Patentanspruch 6,
**dadurch gekennzeichnet,**
**dass** ein Gehäuse (2) das Federelement (10) auf einer Leiterplatte (21) fixiert, und dass das Gehäuse (2) mittels mindestens einer Clipsverbindung (20), einer Klebeverbindung oder dgl.an der Leiterplatte (21) befestigt ist.

9. Schaltvorrichtung (1) nach einem der vorgenannten Patentansprüche,
**dadurch gekennzeichnet,**
**dass** der induktive Sensor (6) in einer Zustellrichtung (8) auf, in oder unter der Leiterplatte (21) angeordnet ist.

10. Schaltvorrichtung (1) nach einem der vorgenannten Patentansprüche,
**dadurch gekennzeichnet,**
**dass** das Federelement (10) einen Sockel (12), den Biegeknickbereich (11) und die Kuppel (13) umfasst und einstückig, vorzugsweise als Spritzgussteil, hergestellt ist.

11. Schaltvorrichtung (1) nach einem der vorgenannten Patentansprüche,
**dadurch gekennzeichnet,**
**dass** der Biegeknickbereich (11) in einem Winkel von 45° > w > 0° zu der Längsachse angeordnet ist.

12. Schaltvorrichtung (1) nach einem der vorgenannten Patentansprüche,
**dadurch gekennzeichnet,**
**dass** die Schaltvorrichtung (1) als Wippenschalter oder als Hubtaster ausgebildet ist.

13. Schaltvorrichtung (1) nach einem der vorgenannten Patentansprüche,
**dadurch gekennzeichnet,**
**dass** der Betätigungskörper (7) eine Schnappscheibe (16) ist, wobei die Schnappscheibe (16) aus einem metallischen Werkstoff hergestellt ist.

14. Federelement (10) für eine Schaltvorrichtung (1) nach einem der vorgenannten Patentansprüche,
**dadurch gekennzeichnet,**
**dass** das Federelement (10) aus einem elastischen und elektrisch isolierenden Werkstoff einstückig hergestellt ist und mindestens einen Biegeknickbereich (11) und eine Kuppe (13) aufweist

15. Federelement (10) für eine Schaltvorrichtung (1) nach einem der vorgenannten Patentansprüche,
**dadurch gekennzeichnet,**
**dass** in die Kuppe (13) eine Aussparung (15) angeformt oder eingearbeitet ist und das in die Aussparung (15) ein Betätigungselement (7) eingesetzt ist oder die Aussparung (15) einen lichtdurchlässigen Bereich (19) bildet.
